(19) **Europäisches Patentamt / European Patent Office / Office européen des brevets**

(11) **EP 1 229 618 B1**

(12) **EUROPEAN PATENT SPECIFICATION**

(45) Date of publication and mention
of the grant of the patent:
**13.02.2008 Bulletin 2008/07**

(51) Int Cl.:
***H01T 4/08*** (2006.01)

(21) Application number: **01121856.7**

(22) Date of filing: **11.09.2001**

(54) **Discharge gap apparatus**

Entladungsspaltvorrichtung

Dispositif de décharge à intervalle

(84) Designated Contracting States:
**DE GB**

(30) Priority: **31.01.2001 JP 2001023968**

(43) Date of publication of application:
**07.08.2002 Bulletin 2002/32**

(73) Proprietor: **KABUSHIKI KAISHA TOSHIBA
Tokyo (JP)**

(72) Inventor: **Hirosawa, Hideki
Minato-ku,
Tokyo 105-8001 (JP)**

(74) Representative: **Henkel, Feiler & Hänzel
Patentanwälte
Maximiliansplatz 21
80333 München (DE)**

(56) References cited:
**US-A- 6 052 269          US-A- 6 084 759**

• **PATENT ABSTRACTS OF JAPAN vol. 2000, no.
06, 22 September 2000 (2000-09-22) & JP 2000
069666 A (SONY CORP), 3 March 2000
(2000-03-03)**

EP 1 229 618 B1

**Description**

This invention relates to a discharge gap apparatus favorably adopted in a power receiving section for receiving power particularly from a commercial AC power supply in a printed circuit board used in TV sets, videotape recorders, and electronic equipment such as communications equipment.

In a printed circuit board of prior art electronic equipment, a power receiving section includes a lightning-stroke protection circuit. This circuit aims at releasing a lightning voltage guided to an external antenna and supplying the resultant lightning voltage toward an external commercial AC power supply. This technique is disclosed in Jpn. Pat. Appln. KOKAI Publication No. 2000-69666.

The lightning-stroke protection circuit includes a discharge gap circuit, and a discharge gap is discharged when lightning strikes. Paying attention to the discharge gap circuit, it is preferable to reduce the discharge gap and drop a lightning surge discharge start voltage in order to smoothly discharge the discharge gap when lightning strikes. Individual countries set their respective standards for safety for the discharge gap circuit. In other words, a distance between the primary and secondary parts (conductors) of the circuit is defined. Because of the standards for safety, the gap cannot be decreased carelessly. The distance between the primary and secondary conductors, which conforms to the standards for safety, contradicts with a reduction in the discharge gap to lower the lightning surge discharge start voltage.

A discharge gap apparatus according to the precharacterizing part of claim 1 is disclosed in JP-A-2000-069666.

It is accordingly an object of the present invention to provide a discharge gap apparatus that is capable of decreasing a lightning surge discharge start voltage without reducing an interval between primary and secondary terminals.

According to the present invention the above object is achieved by a discharge gap apparatus according to claim 1. The dependent claims are directed to further advantageous aspects of the invention.

With the above structure, an interval between the primary and secondary terminals satisfies the standards for safety. Even under the circumstances, the capacitor fulfills a function of inducing discharge. The discharge start voltage can thus be lowered to obtain smooth discharge.

The invention can be more fully understood from the following detailed description when taken in conjunction with the accompanying drawings, in which:

FIG. 1 is a diagram showing a basic structure of a discharge gap apparatus according to a first embodiment of the present invention;
FIG. 2 is a diagram of a charge gap apparatus according to a second embodiment of the present invention;
FIG. 3 is a diagram of a charge gap apparatus according to a third embodiment of the present invention;
FIG. 4 is a circuit diagram of a power receiving section to which the present invention is applied; and
FIGS. 5A to 5E are diagrams each showing another example of the present invention.

Embodiments of the present invention will now be described with reference to the accompanying drawings.

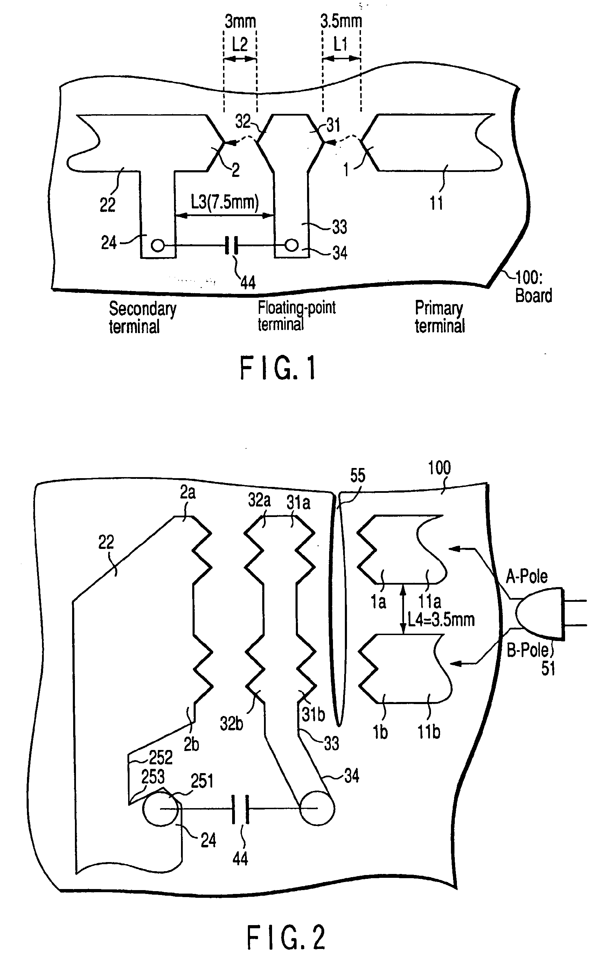

FIG. 1 illustrates a basic structure of a discharge gap apparatus according to a first embodiment of the present invention. In FIG. 1, reference numeral 100 indicates a printed wiring board. Primary and secondary terminals 11 and 22 are printed by patterning on the printed wiring board 100. The primary terminal 11 includes a primary discharge section 1 for discharge, while the secondary terminal 22 includes a secondary discharge section 2 for discharge.

A floating-point terminal 33 is printed by patterning between the primary and secondary terminals 11 and 22. This terminal 33 has first and second floating-point discharge sections 31 and 32 on a line connecting the primary and secondary discharge sections 1 and 2. These sections 31 and 32 are integrated as one component.

A capacitor 44 for connecting the floating-point terminal 33 and the secondary terminal 22 is provided away from the line connecting the sections 1 and 2. The capacitor 44 is located in a space having a distance L3 (e.g., 7.5 mm) that is greater than the shortest distance between the terminals 22 and 33. The terminals 22 and 33 have their extended terminal portions 24 and 34, respectively.

The foregoing discharge gap apparatus has a two-stage discharge gap structure. In this structure, a first discharge gap is formed between the primary discharge section 1 and the first floating-point discharge section 31 and a second discharge gap is formed between the second floating-point discharge sections 32 and the secondary discharge section 2. As described above, the capacitor 44 (which satisfies a standard for withstand voltages) is connected between the secondary terminal 22 and the floating-point terminal 33 to lower a lightning surge discharge start voltage.

The fact that the circuit arrangement of the above discharge gap apparatus satisfies a design standard will now be described. The total of the first discharge gap L1 (e.g., 3.5 mm) and the second discharge gap L2 (e.g., 3 mm) is 6 mm or more. This value satisfies standards for safety (IEC, UL, CSA, and the Electrical Appliance and Material Control Law) that define a gap between the primary and secondary conductors.

In the normal operation, the UL, CSA and Electrical Appliance and Material Control Law require that no discharge occur when a withstand voltage between the primary and secondary terminals 11 and 22 is not higher than 1.0 kV (r.m.s.

value) → 1 kV × √2 = 1.41 kV (0-peak) or no electrical breakdown be produced. The IEC-65 requires that no discharge occur when the withstand voltage is not higher than 3.0 kV (r.m.s. value) → 3kV × √2 = 4.4 kV (0-peak). In order to meet the requirements, a given gap should be set between the primary and secondary terminals.

The capacitor 44 is connected between the secondary terminal 22 and the floating-point terminal 33 which are separated from each other with a gap of 3 mm therebetween. The capacitor 44 conforms to the standards for safety and satisfies an insulating function under the standards. As the capacitor 44, a line bypass capacitor (popularly called a Y capacitor) is adopted to satisfy the standards for safety in each country. Under the IEC standard, the capacitor is classified as IEC 384-14, second edition, class II. Under the UL and CSA standards, it is classified as IEC 348-14, second edition, class I (or class II). Under the Electrical Appliance and Material Control Law, it is classified as IEC 348-14, second edition, class I or class II. The design standard is therefore satisfied even though the capacitor 44 is provided.

A function of the two-stage discharge gap, which is carried out when a lightning surge occurs, will now be described.

Since the capacitor 44 is connected between the floating-point terminal 33 and the secondary terminal 22, these terminals are insulated from each other at the same potential in the early stage. If a lightning voltage is guided, discharge (a short circuit) is caused between the primary discharge section 1 of the primary terminal 11 and the first floating-point discharge section 31 of the floating-point terminal 33 and then between the second floating-point discharge section 32 of the floating-point terminal 33 and the secondary discharge section 2 of the secondary terminal 22. Consequently, the primary and secondary terminals are discharged.

In the apparatus of the present invention, the capacitor 44 allows a lightning surge discharge start voltage to drop when lightning strikes. The reason for this is as follows. Assuming now that the impedance of the capacitor 44 is Zc, the following equation is given:

$$\mathtt{Zc} = (1/\omega\mathtt{C}) = (1/2\pi\mathtt{f}\cdot\mathtt{C}) = (1/2\pi\mathtt{C}) \times (1/\mathtt{f})$$

where f is frequency and C is capacitance of the capacitor 44.

Since the lightning voltage has a high frequency, the capacitor 44 is considered to be short-circuited when lightning strikes. This situation is equal to the application of a lightning voltage only between the primary terminal 11 and the floating-point terminal 33. The narrower the gap, the lower the discharge start voltage. Thus, the discharge start voltage in the above apparatus is lower than that in an apparatus having no capacitors.

Discharge means that an insulator is punctured and short-circuited. The short-circuited portion is located between the primary discharge section 1 and the first floating-point discharge section 31 and between the second floating-point discharge section 32 and the secondary discharge section 2. Discharge current flows through the short-circuited portion and not through the capacitor 44. This phenomenon depends upon the connecting position of the capacitor 44. In other words, the capacitor 44 is located at a distance from the line connecting the primary and secondary discharge sections 1 and 2, and connects the secondary discharge section 2 and the second floating-point discharge section 32 in a space whose width L3 is greater than the shortest distance L2.

The advantages of the present invention are summarized as follows:

(1) The lightning surge discharge start voltage between the primary and secondary terminals can be lowered without narrowing a gap between these terminals (the lightning surge discharge start voltage can be lowered though the gap is the same as a common one-stage discharge gap).

(2) The discharge gap apparatus of the present invention can be manufactured at low cost because it can be achieved by adding pattern design (floating-point terminal) and one capacitor to a conventional discharge gap apparatus.

(3) The capacitor in use conforms to the standards for safety. No special parts are required. The standards for safety can thus easily be obtained for the discharge gap apparatus of the present invention.

(4) Since no parts are connected between the primary and secondary terminals, no leakage current increases, no capacitance increases, no noise propagates, no power-supply radiation varies, or no polarities exist.

(5) Since discharge is caused by only the discharge gap, a component (provided on the substrate) whose lightning surge discharge withstand voltage is low can be used. When an interval between the primary and secondary terminals is determined in the substrate pattern, the lower limit (small value) of standards for safety can be selected and the area of the substrate can be reduced.

(6) Since no lightning surge discharge current flows through the capacitor, the capacitor increases in lightning discharge withstand voltage and in lifetime and improves in durability.

(7) Even though a discharge section for A-pole and B-pole of a commercial AC power supply is provided at the primary terminal, one capacitor has only to be used, as will be described later.

(8) The discharge gap circuit can be conformed to the standards for safety of individual countries by adjusting the gap lengths L1 and L2.

(9) As will be described later, an opening is formed in the board in the locations of the primary and secondary discharge gaps. Therefore, no carbon is adhered to gap portions during the discharge, and the same discharge start voltage as that in the early stage of the next discharge can stably be generated.

FIG. 2 illustrates a discharge gap apparatus according to a second embodiment of the present invention. The constituting elements of the apparatus, which correspond to those of the first embodiment, will be described with the same reference numerals assigned thereto. In FIG. 2, reference numeral 100 indicates a printed wiring board on which terminals (described below) are printed by patterning.

Reference numeral 51 denotes a plug connected to a commercial AC power supply. One line (A pole) of the plug is connected to an A-pole primary terminal 11a and the other line (B pole) thereof is connected to a B-pole primary terminal 11b. The A-pole primary terminal 11a includes a primary discharge section 1a for discharge, while a secondary terminal 22 includes a secondary discharge section 2a for discharge. The B-pole primary terminal 11b includes a primary discharge section 1b for discharge, while the secondary terminal 22 includes a secondary discharge section 2b for discharge.

The primary terminals 11a and 11b are arranged in parallel with and independently of each other. A floating-point terminal 33 is printed by patterning between the primary terminals 11a and 11b and the secondary terminal 22. The terminal 33 includes a first floating-point discharge section 31a and a second floating-point discharge section 32a on a line connecting the primary and secondary discharge sections 1a and 2a. The discharge sections 31a and 32a are integrated as one component. The terminal 33 also includes a first floating-point discharge section 31b and a second floating-point discharge section 32b on a line connecting the primary and secondary discharge sections 1b and 2b. The discharge sections 31b and 32b are integrated as one component.

A capacitor 44 for connecting the secondary terminal 22 and the floating-point terminal 33 is provided at a distance from the primary discharge sections 1a and 1b and the secondary discharge sections 2a and 2b. The capacitor 44 is located in a space having a distance L3 (e.g., 7.5 mm) that is greater than the shortest distance between the terminals 22 and 33. Thus, the terminals 22 and 33 have their extended terminal portions 24 and 34, respectively.

The secondary terminal 22 has a notch 253 such that a portion 251 of the terminal 22, which is connected to the capacitor 44, separates from an edge 252 of the secondary terminal 22 through which a discharge current is easy to flow. The notch 253 is effective in preventing a discharge current from flowing into the capacitor 44 when lightning strikes.

The board 100 has a slit-like opening 55. The discharge sections 1a, 1b, 31a, 32a, 31b, 32b, 2a and 2b each have a pair of pointed projections toward a discharge gap. The second embodiment fulfills the same function as that of the first embodiment described above.

Even though two discharge sections are provided at the primary terminal for A- and B-poles of a commercial AC power supply, one capacitor has only to be used. Since the opening 55 is formed in the board in the locations of the primary and secondary discharge gaps, no carbon is adhered to the gap portions during the discharge, with the result that the same discharge start voltage as that in the early stage of the next discharge can stably be generated. Since, moreover, each discharge section has a pair of pointed projections, discharge can be caused from one of the projections even though the other projection is broken. Distance L4 between the A-pole and B-pole primary terminals 11a and 11b is, for example, 3.5 mm or more so as to satisfy the standard of an AC input section.

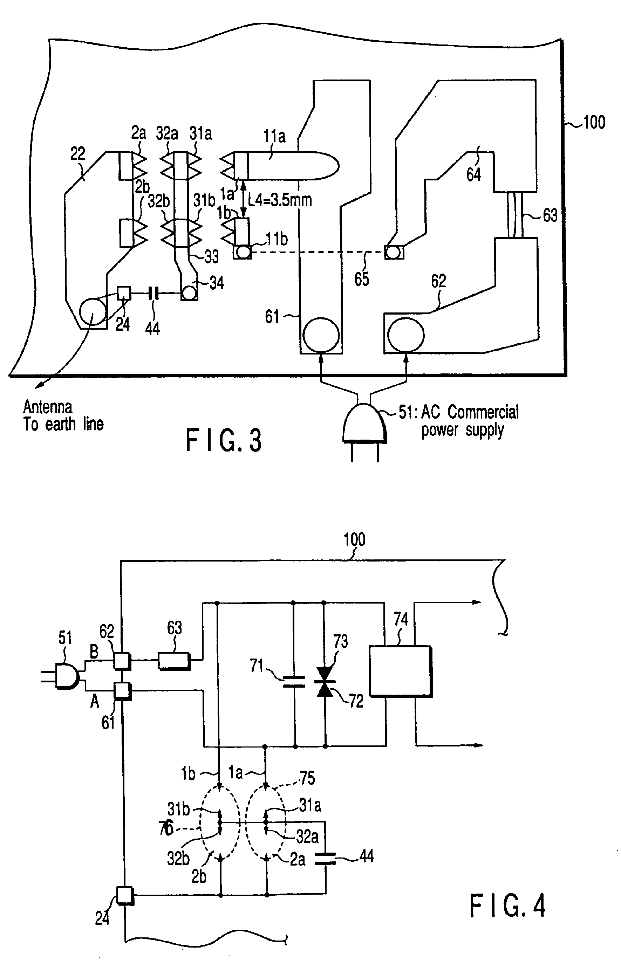

FIG. 3 depicts a charge gap apparatus according to a third embodiment of the present invention. The constituting elements of the apparatus, which correspond to those of the second embodiment, will be described with the same reference numerals assigned thereto. In the third embodiment, an A-pole line of a plug 51 is connected to a primary terminal 11a via a printed pattern 61, while a B-pole line thereof is connected to another primary terminal 11b via a printed pattern 62, a fuse 63, a printed pattern 64, and a jumper wire 65. The other elements are almost the same as those of the apparatus shown in FIG. 2. Each of discharge sections 1a, 1b, 31a, 32a, 31b, 32b, 2a and 2b are thickened because solder is attached thereto. Thus, the discharge sections can maintain their durability even though they are cut by discharge. While the thickness of a printed wiring pattern is 35 microns, that of the thickest solder portion of each discharge section is about 0.5 mm.

FIG. 4 is a circuit diagram simply showing a power receiving section to which the present invention is applied. The constituents corresponding to those of the above embodiments are denoted by the same reference numerals. In the power receiving section, an A-pole of a power line is connected to a printed pattern 61 and a B-pole thereof is connected to another printed pattern 62. A capacitor 71 is an insulating capacitor connected between A-pole and B-pole lines. Diodes 72 and 73 are connected in series between these lines as protection circuits. Numeral 74 indicates a transformer for transforming an input voltage. It is discharge sections 75 and 76 that the present invention is applied to.

The present invention is not limited to the above-described embodiments. According to the embodiments, the discharge gap apparatus is provided on a printed wiring board having a power receiving section and a secondary terminal integrally as one component. However, it is needless to say that the elements as shown in FIGS. 1, 2 and 3 can be constituted as a single component.

Let us explain distance W between the primary and secondary terminals 11 and 22 each constituting a discharge section under the standards of the Electrical Appliance and Material Control Law, UL, CSA and IEC-65. The distance W is 2.0 mm or longer under the standard of the Electrical Appliance and Material Control Law, 3.2 mm or longer under the UL standard, 3.0 mm or longer under the CSA standard, and 6.0 mm or longer under the IEC-65 standard. Providing a floating-point terminal 33 as in the present invention, its position has to be determined so as to satisfy the distance W. In other words, distance W1 should be set between the discharge sections 1 and 31 and so should be distance W2 between the discharge sections 32 and 2.

The following are allowable values of the distances W1 and W2. Under the standard of the Electrical Appliance and Material Control Law, distance W1 is 1.0 mm to 2.8 mm (preferably 2.0 mm) and distance W2 is 1.0 mm to 2.1 mm (preferably 1.5 mm). The standard of the Electrical Appliance and Material Control Law is therefore satisfied when distance W is 2 mm or longer. Under the UL standard, distance W1 is 1.0 mm to 3.5 mm (preferably 2.0 mm) and distance W2 is 1.0 mm to 2.0 mm (preferably 1.5 mm). The UL standard is therefore satisfied when distance W is 3.2 mm to 4.0 mm. Under the CSA standard, distance W1 is 1.0 mm to 3.3 mm (preferably 2.0 mm) and distance W2 is 1.0 mm to 2.0 mm (preferably 1.5 mm). The CSA standard is therefore satisfied when distance W is 3.0 mm to 4.0 mm. Under the IEC-65 standard, distance W1 is 3.0 mm to 4.5 mm (preferably 3.5 mm) and distance W2 is 2.0 mm to 4.5 mm (preferably 3.0 mm). The IEC-65 standard is therefore satisfied when distance W is 6.0 mm to 8.0 mm.

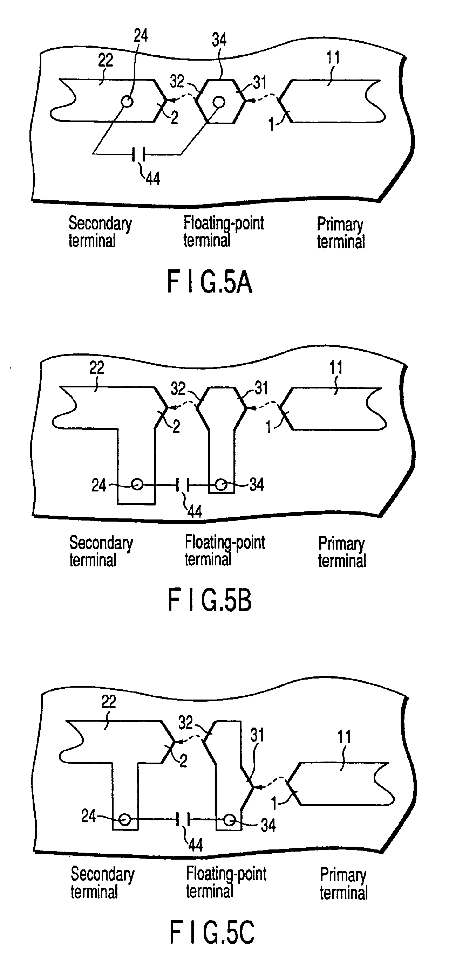

The pattern of the discharge gap apparatus of the present invention is not limited to those shown in FIGS. 1 to 3. The apparatus can be constituted in the patterns as illustrated in FIGS. 5A to 5E.

In the pattern depicted in FIG. 5A, the primary terminal 11, secondary terminal 22 and floating-point terminal 33 are arranged linearly. Terminal portions 24 and 34 are located at a distance from a gap formed between discharge sections 2 and 32. The interval between the terminal portions 24 and 34 is greater than the gap.

In the pattern depicted in FIG. 5B, the secondary terminal 22 and the floating-point terminal 33 are arranged in parallel with a given gap therebetween. The terminal portions 24 and 34 are located at a distance from a gap formed between the discharge sections 2 and 32. The interval between the terminal portions 24 and 34 is greater than the gap.

In the pattern depicted in FIG. 5C, a gap between the discharge sections 1 and 31 and a gap between the discharge sections 2 and 32 are displaced up and down from each other. The terminal portions 24 and 34 are located at a distance from the gap formed between the discharge sections 2 and 32. The interval between the terminal portions 24 and 34 is greater than the gap.

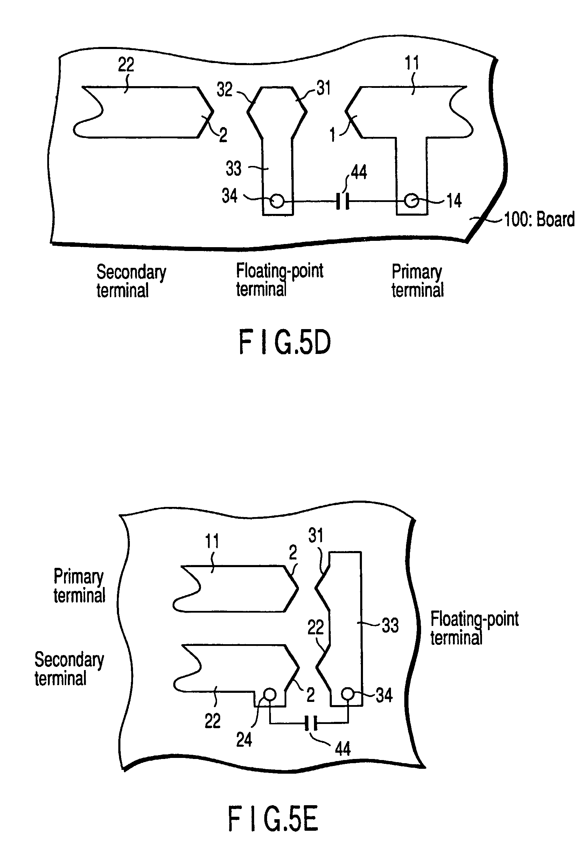

In the pattern depicted in FIG. 5D, a terminal portion 14 is provided at the primary terminal 11 and a capacitor 44 is connected between the terminal portion 14 and the terminal portion 34 of the floating-point terminal 33. The terminal portions 14 and 34 are located at a distance from a gap formed between the discharge sections 1 and 31. The interval between the terminal portions 14 and 34 is greater than the gap.

In the pattern depicted in FIG. 5E, the primary and secondary terminals 11 and 22 are arranged up and down, and a floating-point terminal 33 is provided opposite to the discharge sections 1 and 2. Discharge sections 31 and 32 are formed at the terminal 33 so as to face the discharge sections 1 and 2. In this pattern, too, the terminal portions 24 and 34 are located a distance from a gap formed between the discharge sections 2 and 32, and the interval between the terminal portions 24 and 34 is greater than the gap.

Various modifications to the above-described patterns can be made.

**Claims**

1. A discharge gap apparatus comprising:

   a primary terminal (11) having a first discharge section (1) ;
   a secondary terminal (22) having a second discharge section (2) and arranged at a given distance from the primary terminal;
   a floating-point terminal (33) provided close to the first discharge section (1) and the second discharge section (2) and having third and fourth discharge sections (31, 32) opposed to the first and second discharge sections (1, 2), respectively, a first gap (L1) being formed between the first and third discharge sections, and a second gap (L2) being formed between the second and fourth discharge sections;

   wherein said discharge gap apparatus is **characterized by**:

   connecting terminal sections (24, 34) provided in the secondary terminal (22) and floating-point terminal (33), respectively and located away from the second gap (L2), an interval between the connecting terminal sections being greater than the second gap; and
   a capacitor (44) connected directly between the connecting terminal sections.

2. The discharge gap apparatus according to claim 1, **characterized in that** a total (L1 + L2) of the first gap and the second gap is set to satisfy an insulation standard.

3. The discharge gap apparatus according to claim 1, **characterized in that** the primary terminal (11) includes a pair of terminals (11a, 11b), each having a discharge section, which is connected to a commercial AC power supply constituting a primary circuit and the secondary terminal (22) is connected to a connection point of a secondary circuit.

4. The discharge gap apparatus according to claim 1, **characterized in that** the first gap (L1) and the second gap (L2) are arranged linearly.

5. The discharge gap apparatus according to claim 1, **characterized in that** the primary and secondary terminals (11, 22) are arranged on an insulating substrate at regular intervals.

6. The discharge gap apparatus according to claim 1, **characterized in that** the primary terminal (11), the secondary terminal (22) and the floating-point terminal (33) are printed on a printed wiring board (100).

7. The discharge gap apparatus according to claim 1, **characterized in that** solder is attached to the first, second, third and fourth discharge sections.

8. The discharge gap apparatus according to claim 1, **characterized in that** the discharge sections (1, 31; 2, 32) opposed to each other each have a plurality of pointed projections.

9. The discharge gap apparatus according to claim 6, **characterized in that** a slit (55) is formed in the printing wiring board in the location of the first and/or second gaps.

10. The discharge gap apparatus according to claim 1, **characterized in that** when a size of the first gap is W1 and a size of the second gap is W2, W1 = 3.0 mm to 4.5 mm, preferably 3.5 mm, W2 = 2.0 mm to 4.5 mm, preferably 3.0 mm, and W1 + W2 = 6.0 mm to 8.0 mm.

11. The discharge gap apparatus according to claim 1, **characterized in that** when the size of the first gap is W1 and the size of the second gap is W2, W1 = 1.0 mm to 2.8 mm, preferably 2.0 mm, W2 = 1.0 mm to 2.1 mm, preferably 1.5 mm, and W1 + W2 = 2.0 mm or more.

12. The discharge gap apparatus according to claim 1, **characterized in that** when the size of the first gap is W1 and the size of the second gap is W2, W1 = 1.0 mm to 3.5 mm, preferably 2.0 mm, W2 = 1.0 mm to 2.0 mm, preferably 1.5 mm, and W1 + W2 = 3.2 mm to 4.0 mm.

13. The discharge gap apparatus according to claim 1, **characterized in that** when the size of the first gap is W1 and the size of the second gap is W2, W1 = 1.0 mm to 3.3 mm, preferably 2.0 mm, W2 = 1.0 mm to 2.0 mm, preferably 1.5 mm, and W1 + W2 = 3.0 mm to 4.0 mm.

14. The discharge gap apparatus according to claim 1, **characterized in that** the primary terminal (11) includes a pair of terminals (11a, 11b) each having a primary discharge section, the secondary terminal (22) includes a pair of second discharge sections (2a, 2b), and the floating-point terminal (33) includes pairs of third and fourth discharge sections (31a, 31b; 32a, 32b).

15. The discharge gap apparatus according to claim 14, **characterized in that** an interval between the terminals of the primary terminal is set at 3.5 mm or more.

**Patentansprüche**

1. Entladungsspaltvorrichtung, **gekennzeichnet durch**:

   einen ersten Anschluss (11) mit einem ersten Entladungsabschnitt (1) ;
   einen zweiten Anschluss (22), der einen zweiten Entladungsabschnitt (2) aufweist und mit einem gegebenen Abstand von dem ersten Anschluss angeordnet ist;
   einen Floating-Point-Anschluss (33), der nahe dem ersten Entladungsabschnitt (1) und dem zweiten Entladungsabschnitt (2) vorgesehen ist und dritte und vierte Entladungsabschnitten (31, 32) aufweist, die den ersten bzw. zweiten Entladungsabschnitten (1, 2) gegenüberliegen, wobei ein erster Spalt (L1) zwischen den ersten und dritten Entladungsabschnitten und ein zweiter Spalt (L2) zwischen den zweiten und vierten Entladungsabschnitten gebildet wird;

wobei die Entladungsspaltvorrichtung **gekennzeichnet ist durch**:

Anschlussverbindungsabschnitte (24, 34), die in dem zweiten Anschluss (2) und Floating-Point-Anschluss (33), vorgesehen sind und von dem zweiten Spalt (L2) entfernt angeordnet sind, wobei ein Intervall zwischen den Anschlussverbindungsabschnitten größer als der zweite Spalt ist; und
einen Kondensator (44), der direkt zwischen den Anschlussverbindungsabschnitten geschaltet ist.

2. Entladungsspaltvorrichtung gemäß Anspruch 1, **dadurch gekennzeichnet, dass** ein Gesamtbetrag (L1 + L2) des ersten Spalts und des zweiten Spalts eingestellt ist, um einen Isolierungsstandard zu erfüllen.

3. Entladungsspaltvorrichtung gemäß Anspruch 1, **dadurch gekennzeichnet, dass** der erste Anschluss (11) ein Paar von Anschlüssen (11a, 11b) aufweist, die jeweils einen Entladungsabschnitt aufweisen, der mit einer handelsüblichen Wechselstromversorgung verbunden ist, die einen ersten Schaltkreis bildet, und der zweite Anschluss (22) mit einem Verbindungspunkt eines zweiten Schaltkreises verbunden ist.

4. Entladungsspaltvorrichtung gemäß Anspruch 1, **dadurch gekennzeichnet, dass** der erste Spalt (L1) und der zweite Spalt (L2) linear angeordnet sind.

5. Entladungsspaltvorrichtung gemäß Anspruch 1, **dadurch gekennzeichnet, dass** die ersten und zweiten Anschlüsse (11, 22) auf einem isolierenden Substrat mit regelmäßigen Intervallen angeordnet sind.

6. Entladungsspaltvorrichtung gemäß Anspruch 1, **dadurch gekennzeichnet, dass** der erste Anschluss (11), der zweite Anschluss (22) und der Floating-Point Anschluss (33) auf einer gedruckten Schaltung (100) gedruckt sind.

7. Entladungsspaltvorrichtung gemäß Anspruch 1, **dadurch gekennzeichnet, dass** Lötmittel an den ersten, zweiten, dritten und vierten Entladungsabschnitten befestigt ist.

8. Entladungsspaltvorrichtung gemäß Anspruch 1, **dadurch gekennzeichnet, dass** die einander gegenüberliegenden Entladungsabschnitte (1, 31; 2, 32) jeweils eine Mehrzahl von spitzen Vorsprüngen aufweisen.

9. Entladungsspaltvorrichtung gemäß Anspruch 6, **dadurch gekennzeichnet, dass** ein Schlitz (55) in der gedruckten Schaltung in der Stelle des ersten and/oder zweiten Spalts ausgebildet ist.

10. Entladungsspaltvorrichtung gemäß Anspruch 1, **dadurch gekennzeichnet, dass**, wenn eine Größe des ersten Spalts W1 und eine Größe des zweiten Spalts W2 ist, W1 = 3,0 mm bis 4,5 mm, vorzugsweise 3,5 mm, W2 = 2,0 mm bis 4,5 mm, vorzugsweise 3,0 mm, und W1 + W2 = 6,0 mm bis 8,0 mm ist.

11. Entladungsspaltvorrichtung gemäß Anspruch 1, **dadurch gekennzeichnet, dass**, wenn die Größe des ersten Spalts W1 und die Größe des zweiten Spalts W2 ist, W1 = 1,0 mm bis 2,8 mm, vorzugsweise 2,0 mm, W2 = 1,0 mm bis 2,1 mm, vorzugsweise 1,5 mm, und W1 + W2 = 2,0 mm oder mehr ist.

12. Entladungsspaltvorrichtung gemäß Anspruch 1, **dadurch gekennzeichnet, dass**, wenn die Größe des ersten Spalts W1 und die Größe des zweiten Spalts W2 ist, W1 = 1,0 mm bis 3,5 mm, vorzugsweise 2,0 mm, W2 = 1,0 mm bis 2,0 mm, vorzugsweise 1,5 mm, und W1 + W2 = 3,2 mm bis 4,0 mm ist.

13. Entladungsspaltvorrichtung gemäß Anspruch 1, **dadurch gekennzeichnet, dass**, wenn die Größe des ersten Spalts W1 und die Größe des zweiten Spalts W2 ist, W1 = 1,0 mm bis 3,3 mm, vorzugsweise 2,0 mm, W2 = 1,0 mm bis 2,0 mm, vorzugsweise 1,5 mm, und W1 + W2 = 3,0 mm bis 4,0 mm ist.

14. Entladungsspaltvorrichtung gemäß Anspruch 1, **dadurch gekennzeichnet, dass** der erste Anschluss (11) ein Paar von Anschlüssen (11a, 11b) aufweist, die jeweils einen ersten Entladungsabschnitt aufweisen, der zweite Anschluss (22) ein Paar von zweiten Entladungsabschnitten (2a, 2b) aufweist und der Floating-Point-Anschluss (33) Paare von dritten und vierten Entladungsabschnitten (31a, 31b; 32a, 32b) aufweist.

**15.** Entladungsspaltvorrichtung gemäß Anspruch 14, **dadurch gekennzeichnet, dass** ein Intervall zwischen den Anschlüssen des primären Anschlusses auf 3,5 mm oder mehr eingestellt ist.

**Revendications**

**1.** Dispositif à interstice de décharge, comprenant :

une borne (11) primaire ayant une première section (1) de décharge ;
une borne (22) secondaire ayant une deuxième section (2) de décharge et disposée à une distance donnée de la borne primaire ;
une borne (33) formant point flottant prévue à proximité de la première section (1) et de la deuxième section (2) de décharge et ayant des troisième et quatrième sections (31, 32) de décharge respectivement opposées aux première et deuxième sections (1, 2) de décharge, un premier interstice (L1) étant formé entre les première et troisième sections de décharge et un deuxième interstice (L2) étant formé entre les deuxième et quatrième sections de décharge ;

dans lequel le dispositif à interstice de décharge est **caractérisé par** :

des sections (24, 34) de bornes de connexion respectivement prévues dans la borne (22) secondaire et la borne (33) formant point flottant, et situées loin du deuxième interstice (L2), l'intervalle entre les sections de borne de connexion étant plus grand que le deuxième interstice ; et
un condensateur (44) connecté directement entre les sections de bornes de connexion.

**2.** Dispositif à interstice de décharge suivant la revendication 1, **caractérisé en ce qu'**un total (L1 + L2) du premier interstice et du deuxième interstice est réglé de façon à respecter une norme d'isolation.

**3.** Dispositif à interstice de décharge suivant la revendication 1, **caractérisé en ce que** la borne primaire (11) comprend une paire de bornes (11a, 11b) ayant chacune une section de décharge qui est connectée à une alimentation électrique à courant alternatif du commerce constituant un circuit primaire et **en ce que** la borne (22) secondaire est connectée à un point de connexion d'un circuit secondaire.

**4.** Dispositif à interstice de décharge suivant la revendication 1, **caractérisé en ce que** le premier interstice (L1) et le deuxième interstice (L2) sont disposés linéairement.

**5.** Dispositif à interstice de décharge suivant la revendication 1, **caractérisé en ce que** les bornes primaire et secondaire (11, 22) sont disposées sur un substrat isolant à des intervalles réguliers.

**6.** Dispositif à interstice de décharge suivant la revendication 1, **caractérisé en ce que** la borne (11) primaire, la borne (22) secondaire et la borne (33) formant point flottant sont imprimées sur une carte (100) de circuit imprimé.

**7.** Dispositif à interstice de décharge suivant la revendication 1, **caractérisé en ce que** de la soudure est fixée à des première, deuxième, troisième et quatrième sections de décharge.

**8.** Dispositif à interstice de décharge suivant la revendication 1, **caractérisé en ce que** les sections de décharge (1, 31 ; 2, 32) opposées l'une à l'autre ont chacune une pluralité de protubérances pointues.

**9.** Dispositif à interstice de décharge suivant la revendication 6, **caractérisé en ce qu'**une fente (55) est formée dans la carte de circuit imprimé à l'emplacement des premier et/ou deuxième interstices.

**10.** Dispositif à interstice de décharge suivant la revendication 1, **caractérisé en ce que** lorsque la dimension du premier interstice est W1 et la dimension du deuxième interstice est W2, on a W1 = 3,0 mm à 4,5 mm, de préférence 3,5 mm, W2 = 2,0 mm à 4,5 mm, de préférence 3,0 mm, et W1 + W2 = 6,0 mm à 8,0 mm.

**11.** Dispositif à interstice de décharge suivant la revendication 1, **caractérisé en ce que** lorsque la dimension du premier interstice est W1 et la dimension du deuxième interstice est W2, on a W1 = 1,0 mm à 2,8 mm, de préférence 2,0 mm, W2 = 1,0 mm à 2,1 mm, de préférence 1,5 mm, et W1 + W2 = 2,0 mm ou plus.

**12.** Dispositif à interstice de décharge suivant la revendication 1, **caractérisé en ce que** lorsque la dimension du premier interstice est W1 et la dimension du deuxième interstice est W2, on a W1 = 1,0 mm à 3,5 mm, de préférence 2,0 mm, W2 = 1,0 mm à 2,0 mm, de préférence 1,5 mm, et W1 + W2 = 3,2 mm à 4,0 mm.

**13.** Dispositif à interstice de décharge suivant la revendication 1, **caractérisé en ce que** lorsque la dimension du premier interstice est W1 et la dimension du deuxième interstice est W2, W1 = 1,0 mm à 3,3 mm, de préférence 2,0 mm, W2 = 1,0 mm à 2,0 mm, de préférence 1,5 mm, et W1 + W2 = 3,0 mm à 4,0 mm.

**14.** Dispositif à interstice de décharge suivant la revendication 1, **caractérisé en ce que** la borne (11) primaire comporte une paire de bornes (11a, 11b) ayant chacune une section de décharge primaire, la borne (22) secondaire comporte une paire de deuxièmes sections (2a, 2b) de décharge, et la borne (33) formant point flottant comporte des paires de troisième et quatrième sections de décharge (31a, 31b ; 32a, 32b).

**15.** Dispositif à interstice de décharge suivant la revendication 14, **caractérisé en ce que** l'intervalle entre les bornes de la borne primaire est fixé à 3,5 mm ou plus.

FIG. 1

FIG. 2

F I G. 3

Antenna
To earth line

51: AC Commercial
power supply

F I G. 4

Secondary
terminal

Floating-point
terminal

Primary
terminal

F I G.5A

Secondary
terminal

Floating-point
terminal

Primary
terminal

F I G.5B

Secondary
terminal

Floating-point
terminal

Primary
terminal

F I G.5C

Secondary
terminal

Floating-point
terminal

Primary
terminal

F I G.5D

Primary
terminal

Secondary
terminal

Floating-point
terminal

F I G.5E

**EP 1 229 618 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000069666 A